# FASCICULE DE BREVET EUROPEEN

(11) **EP 0 469 507 B1**
(45) Date de publication et mention de la délivrance du brevet: **11.09.1996**
(21) Numéro de dépôt: 91112697.7
(22) Date de dépôt: 29.07.1991
(51) Int. Cl.: G06F 11/26, G01R 31/28

(54) **Circuit intégré comprenant une cellule standard, une cellule d'application et une cellule de test**
Integrierte Schaltung mit einer Standardzelle, einer Anwendungszelle und einer Prüfzelle
Integrated circuit comprising a standard cell, an application cell and a test cell

(30) Priorité: 03.08.1990 FR 9009978
(43) Date de publication de la demande: 05.02.1992
(73) Titulaire: ALCATEL MOBILE COMMUNICATION FRANCE, 75008 Paris (FR)
(72) Inventeur: Dartois, Luc, F-78955 Carrieres sous Poissy (FR); Dulongpont, Jacques, F-95300 Pontoise (FR); Reusens, Peter, B-9270 Laarne (BE)
(74) Mandataire: Weinmiller, Jürgen

(56) Documents cités:
- EP-A- 0 315 475
- EP-A- 0 358 376
- US-A- 4 698 588
- COMPUTER DESIGN, vol. 29, no. 17, 1 septembre 1990, Littleton, Massachusetts, US, pages 94-112; J. GABAY: "How much can Design-for-test reduce the need for testing?"
- IBM TECHNICAL DISCLOSURE BULLETIN, vol. 25, no. 2, juillet 1982, NEW YORK, US, page 709; E.F. HAHN et al.: "VLSI testing by on-chip error detection"

## Description

La présente invention concerne un circuit intégré comprenant une cellule standard, une cellule d'application et une cellule de test prévue notamment pour contrôler les signaux de communications entre les deux cellules précédentes.

Les dispositifs électroniques actuels, particulièrement ceux qui traitent des signaux numériques, comprennent souvent un organe programmable tel qu'un microprocesseur associé à une mémoire de programme et un circuit d'application regroupant des circuits périphériques de l'organe programmable et des circuits logiques spécifiques aux fonctions que doivent remplir ces dispositifs. Ils sont couramment implantés sur une carte électronique où l'organe programmable et sa mémoire sont deux composants standards tandis que le circuit d'application est généralement un circuit intégré à application spécifique. L'ensemble des liaisons entre ces trois composants est donc apparent sur la carte et un équipement de test ou d'émulation peut donc y accéder afin de permettre les différentes phases de test et de mise au point intervenant dans le développement de tels dispositifs.

L'évolution technologique de la microélectronique permet d'envisager d'intégrer dans un seul composant les différents éléments qui figuraient auparavant sur une telle carte. L'organe programmable est la plupart du temps une cellule standard définie par le fabricant d'un tel composant alors que le circuit d'application est spécifié par le concepteur du composant. La mémoire de programme qui est également fréquemment un sous-ensemble standard sera ici arbitrairement réunie avec le circuit d'application pour constituer ce qui sera maintenant dénommé la cellule d'application. Dans ce mode de réalisation, les liaisons accessibles du dispositif qui sont seulement les broches du composant, sont en nombre réduit par rapport à une réalisation sur carte, car la plupart des liaisons de communication entre la cellule standard et la cellule d'application ne sont pas reliées à des broches. En effet, il n'est pas souhaitable d'augmenter significativement le nombre de broches, ce qui accroît les dimensions du composant et son coût. Il peut même arriver que la technologie l'interdise. Il s'ensuit une impossibilité de réaliser les tests et l'émulation de ce composant conformément à la méthode connue. Les étapes successives qui consistaient à mettre au point la cellule d'application, développer le logiciel de la mémoire de programme, mettre au point ce logiciel et finalement mettre au point l'ensemble du dispositif ne peuvent plus être dissociées.

Il est possible de simuler à l'aide d'un outil de conception assistée par ordinateur l'interaction de la cellule standard et de la cellule d'application. Cela permet de vérifier essentiellement le fonctionnement des liaisons de communication entre ces deux cellules. Cependant, de telles simulations sont longues et coûteuses compte tenu de la puissance de calcul des outils de simulation. Les temps de développement et de mise au point du composant deviennent incompatibles avec les contraintes industrielles.

Il est également possible d'obtenir auprès de certains fabricants un kit de composants où l'organe programmable et la cellule d'application sont des éléments discrets. Le dispositif, en phase de test, est alors réalisé sous la forme d'une maquette où les liaisons entre ces deux éléments sont apparentes et qui peut donc faire l'objet d'un traitement similaire à celui effectué sur les cartes électroniques. Dans ce cas, le coût de développement de la maquette s'ajoute au coût du composant entièrement intégré. De plus, les performances du dispositif sous forme de maquette, notamment en matière de vitesse d'exécution, sont notablement réduites par rapport à celles que l'on peut attendre du même dispositif dans sa version intégrée. Il n'est ainsi pas possible de reproduire intégralement cette version. Le problème de limitation en vitesse apparaît de manière particulièrement aiguë lorsque l'organe programmable est un processeur de signal.

Il existe par ailleurs une technique de test et d'émulation connue sous l'expression anglaise "Boundary scan" décrite notamment dans la norme 1149.1 de l'IEEE (abréviation du nom de l'organisme américain Institute of Electrical and Electronics Engineers) qui s'applique dans le cas d'un composant entièrement intégré. Selon cette technique, une cellule de test est interposée entre la cellule standard et la cellule d'application. Elle comprend, pour chaque liaison de communication, une unité de scrutation pourvue d'une mémoire élémentaire, ces mémoires élémentaires étant reliées de manière à former un registre à décalage connecté à des broches du composant. Il est ainsi possible, par l'adjonction d'un nombre réduit de broches d'accès, d'enregistrer et de modifier les signaux de communication transitant sur les liaisons de communication. Cette technique permet de réaliser la mise au point de la cellule d'application. Elle présente cependant l'inconvénient de perturber les liaisons de communication pendant la circulation des informations mémorisées dans le registre à décalage du fait des connexions entre ces éléments.

Lors de la procédure de test et d'émulation, il est par ailleurs nécessaire de pouvoir commander cette cellule de test suite à un état déterminé des différents signaux d'accès à la cellule standard.

Ainsi la société américaine MOTOROLA a défini pour le processeur de signal portant la référence DSP 96000 une technique d'émulation dont la dénomination anglaise est "On chip emulation". Selon cette technique, le processeur de signal qui est alors une cellule standard est complété avec une interface série qui permet de relancer l'exécution après un point d'arrêt et de charger une instruction au moyen d'un ensemble de registres et de comparateurs d'adresse connectés sur les bus de cette cellule destiné à produire de tels points d'arrêt. Il est prévu de relire l'état de ces bus par l'intermédiaire de l'interface série. Cette solution ne concerne pas le cas d'un circuit comprenant également une cellule d'application mais uniquement le cas où la cellule standard est un processeur ouvert, c'est-à-dire dont le bus instruction est accessible ou bien lorsque la mémoire de programme est une mémoire réinscriptible de type RAM. Elle ne permet pas non plus de relire les informations présentes sur les bus indépendemment du fonctionnement de la cellule standard.

De fait, la demande de brevet EP-0 358 376 enseigne une cellule de test comprenant un registre à décalage dans lequel des informations mémorisées peuvent circuler sans perturber les liaisons de communication. Cette cellule de test peut également être commandée en fonction de l'état des signaux d'accès à la cellule standard.

Cependant, lorsque le circuit intégré a été réalisé par le fabricant, il peut arriver qu'une erreur subsiste dans la mémoire de programme qui est souvent une mémoire morte de type ROM. Cette erreur ne peut donc pas être corrigé dans la mémoire. Pour pallier cet inconvénient, certains fabricants proposent d'adjoindre au circuit une mémoire supplémentaire réinscriptible de type EPROM ou EEPROM par exemple. Cette mémoire supplémentaire fait appel à une technologie particulière qui peut amener une limitation des performances du circuit au niveau de sa vitesse de traitement et qui n'est pas nécessairement compatible avec la technologie employée pour le reste du circuit.

L'objet de la présente invention est ainsi la réalisation d'un circuit intégré comprenant une cellule standard, une cellule d'application et une cellule de test dans lequel il est possible de corriger une erreur de la mémoire de programme sans dégrader les performances, au moyen d'une technique compatible avec la fabrication de ce circuit.

L'invention a donc pour but de présenter les moyens qu'il faut ajouter à un circuit intégré comprenant une cellule standard et une cellule d'application pour permettre son test et son émulation dans les mêmes conditions que si ce circuit se présentait sous la forme de composants discrets assemblés sur une carte.

Le circuit intégré selon l'invention comprend une cellule standard une cellule d'application et une cellule de test prévue notamment pour enregistrer ou pour modifier de l'extérieur du circuit intégré la valeur de signaux de communication transitant entre la cellule standard et la cellule d'application, cette cellule standard exécutant des instructions fournies sur un bus instruction par une mémoire de programme localisée dans la cellule d'application en réponse à une adresse d'instruction véhiculée par un bus adresse d'instruction les conducteurs de ces bus constituant des liaisons de communication, et se caractérise en ce que la cellule de test comprend des moyens de dérivation pour remplacer une instruction erronée au moins de la mémoire de programme par une instruction de remplacement préalablement enregistrée dans le circuit intégré en réponse à un état déterminé de certaines au moins des liaisons de communication.

Avantageusement, dans le circuit intégré comprenant une cellule standard, une cellule d'application et une cellule de test, la cellule de test comprenant pour chacune des liaisons de communication une unité de scrutation pourvue d'une mémoire élémentaire connectée à certains moments au moins sur ces liaisons, les mémoires élémentaires étant reliées entre elles pour former un premier registre à décalage, cette cellule de test comprenant aussi un deuxième registre à décalage pourvu d'au moins un premier registre de commande dont les sorties sont reliées chacune à un conducteur d'un premier bus de commande, le circuit intégré comprend un module de comparaison auquel sont respectivement connectés, d'une part le bus de commande et d'autre part certaines au moins des liaisons de comunication pour produire un signal de coïncidence en cas d'identité des signaux qui lui sont respectivement fournis.

De plus, le circuit intégré comprenant une cellule standard, une cellule d'application et une cellule de test, la cellule standard fonctionnant en réponse à un signal de mode de fonctionnement, celle-ci comprend un circuit de déroutement produisant un signal de déroutement pour un état déterminé du signal de mode de fonctionnement si le signal de coïncidence est présent.

Dans un premier mode de réalisation du circuit intégré comprenant une cellule standard, une cellule d'application et une cellule de test, les moyens de dérivation comprennent une mémoire de substitution dont la dernière instruction exécutable est un retour à la mémoire de programme et un multiplexeur de déroutement dont la sortie est raccordée à la place du bus d'instruction dans la cellule standard, dont une première entrée sélectionnée par le signal de déroutement reçoit une instruction de branchement à la mémoire de substitution et dont la deuxième entrée sélectionnée en l'absence du signal de déroutement est raccordée au bus d'instruction.

Selon une première variante du circuit intégré comprenant une cellule standard, une cellule d'application et une cellule de test, la mémoire de substitution est accédée par le bus adresse d'instruction moyennant un circuit de décodage, l'écriture et la lecture se faisant par l'intermédiaire des unités de scrutation du premier registre à décalage associées au bus instruction.

Selon une seconde variante du circuit intégré comprenant une cellule standard, une cellule d'application et une cellule de test, la mémoire de substitution est accédée directement par la cellule standard, l'écriture et la lecture étant commandées par deux nouveaux états du signal de mode de fonctionnement.

Dans un second mode de réalisation du circuit intégré comprenant une cellule standard, une cellule d'application et une cellule de test, les unités de scrutation associées au bus d'instruction dont les liaisons de communication sont composées chacune d'un canal d'entrée et d'un canal de sortie comprennent chacune un premier multiplexeur dont la première entrée est reliée au canal d'entrée dont la sortie est reliée au canal de sortie et dont l'entrée de commande reçoit le signal de déroutement un deuxième multiplexeur dont la deuxième entrée est reliée au canal d'entrée et dont la sortie est reliée à l'entrée d'une mémoire élémentaire cette mémoire élémentaire ayant sa sortie reliée à la deuxième entrée du premier multiplexeur, le premier registre à décalage comprenant la succession des mémoires élémentaires raccordées chacune à la première entrée du deuxième multiplexeur de l'unité de scrutation suivante, les signaux de sorties des mémoires élémentaires, préalablement chargées au moyen du premier registre à décalage formant l'instruction de remplacement et remplaçant alors l'instruction erronée suite à l'apparition du signal de déroutement.

De plus, dans le circuit intégré comprenant une cellule standard, une cellule d'application et une cellule de test, l'unité de scrutation comprend un circuit de mémorisation dont l'entrée de donnée est reliée à la sortie de ladite mémoire élémentaire et dont l'entrée de synchronisation reçoit un signal de déclenchement, la deuxième entrée dudit premier multiplexeur étant reliée non plus à la sortie de la mémoire élémentaire mais à la sortie du circuit de mémorisation.

Les différents objets et caractéristiques de l'invention apparaîtront de manière plus précise dans le cadre d'exemples de réalisation donnés à titre non limitatif en se référant aux figures annexées qui représentent :
- la figure 1, un schéma par blocs du circuit intégré de l'invention,
- la figure 2, un schéma de ce circuit où la cellule de test apparaît de manière plus détaillée,
- la figure 3, le schéma d'un module de scrutation de cette cellule de test,
- la figure 4, un premier mode de réalisation d'une unité de scrutation d'un module de scrutation,
- la figure 5, un deuxième mode de réalisation d'une unité de scrutation d'un module de scrutation,
- la figure 6, un troisième mode de réalisation d'une unité de scrutation d'un module de scrutation,
- la figure 7, un schéma du circuit intégré de l'invention dont la cellule de test présente des caractéristiques additionnelles,
- la figure 8, le schéma des registres de cette cellule de test,
- la figure 9, le schéma d'une cellule standard connue,
- la figure 10, le schéma d'une cellule standard modifiée selon l'invention,
- la figure 11, le schéma d'une variante de cellule standard selon l'invention,
- la figure 12, un détail du circuit intégré selon l'invention.

Les éléments présents dans différentes figures porteront une seule référence.

En préalable à la description de l'invention proprement dite, la structure des différents éléments connus du circuit intégré sera rappelée, ce qui est nécessaire pour une bonne compréhension de cette invention.

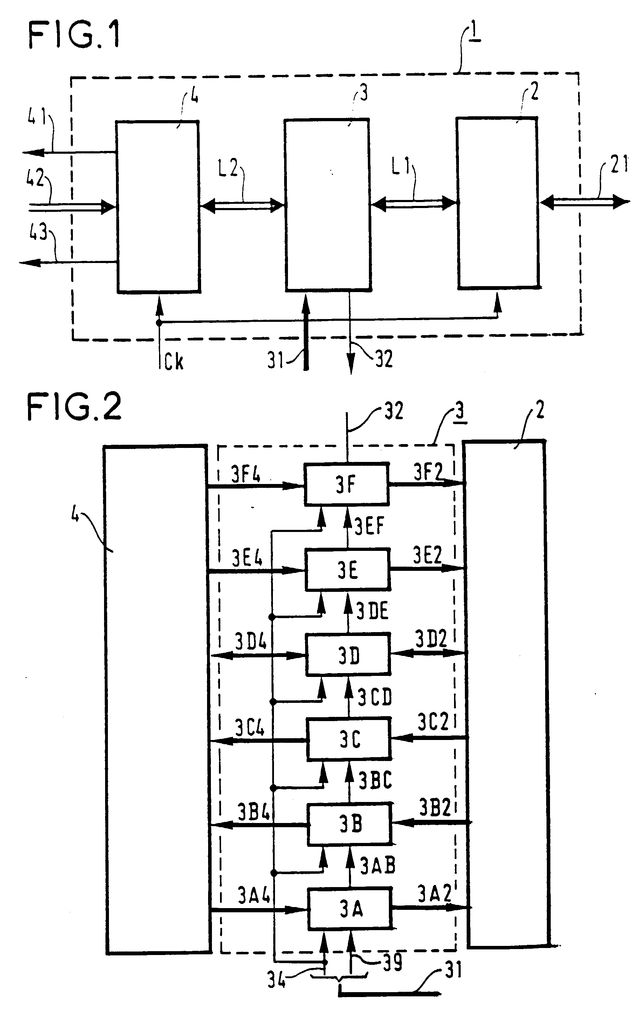

Le circuit intégré 1 représenté schématiquement à la figure 1 comprend essentiellement une cellule d'application 2, une cellule de test 3 et une cellule standard 4 notamment du type programmable tel qu'un microprocesseur, un processeur de signal ou un circuit plus évolué qui est couramment dénommé microcontrôleur. La cellule de test 3 est interposée entre les deux autres cellules de manière à contrôler les différents signaux qu'elles échangent. Ces deux dernières cellules reçoivent un même signal d'horloge Ck.

La cellule d'application 2 est raccordée par une liaison de raccordement 21 à l'extérieur du composant 1. Cette liaison de raccordement constitue l'ensemble des accès d'entrée et de sortie de cette cellule au dispositif sur lequel est monté le composant. Ces accès correspondent donc à des broches. Cette cellule est également reliée à la cellule de test 3 par une première liaison d'échange L1, qui, en dehors de l'invention, serait raccordée directement à la cellule standard 2. Cette première liaison d'échange constitue donc l'ensemble des connexions entre la cellule standard et la cellule d'application qu'il est nécessaire de contrôler. Il peut s'agir, notamment, de bus de contrôle, de liaisons d'écriture, de lecture, de synchronisation, d'interruption, etc.

La cellule standard 4 est reliée à la cellule de test 3 par une deuxième liaison d'échange L2, qui, en dehors de l'invention, se confondrait avec la première liaison d'échange L1.

La cellule de test 3 reçoit des signaux de commande et des informations de modification par une liaison de test 31 et produit des informations donnant l'état des signaux de communications transitant sur les liaisons d'échange, sur une liaison d'observation 32. En mode de fonctionnement normal du circuit intégré 1, la cellule de test établit la connexion entre ces liaisons d'échange et a la possibilité d'enregistrer les signaux de communication sans les modifier. Tout se passe comme si elle n'existait pas pour la cellule standard et pour la cellule d'application. En mode de test ou d'émulation du circuit intégré, la cellule de test a la possibilité d'injecter des données reçues par la liaison de test 31 sur l'une ou l'autre des liaisons d'échange L1, L2.

La cellule de test 3 sera maintenant décrite avec plus de précision en se référant à la figure 2. Dans cet exemple de réalisation, la mémoire de programme de la cellule standard 4 fait partie de la cellule d'application 2. Elle produit l'instruction qui figure à l'emplacement identifié par une adresse d'instruction.

Les deux liaisons d'échange L1, L2, qui véhiculent les signaux de communication sont composées de plusieurs bus de communication.

Des modules de scrutation relient un bus de la première liaison d'échange L1 au bus correspondant de la seconde liaison d'échange L2. Les différents modules de scrutation et les différents bus de communication sont répertoriés dans le tableau qui suit.

| | Module de scrutation | Liaison L1 | Liaison L2 |
|---|---|---|---|
| Bus adresse d'instruction | 3A | 3A2 | 3A4 |
| Bus instruction | 3B | 3B2 | 3B4 |
| Bus entrées de contrôle | 3C | 3C2 | 3C4 |
| Bus données | 3D | 3D2 | 3D4 |
| Bus sorties de contrôle | 3E | 3E2 | 3E4 |
| Bus adresse de données | 3F | 3F2 | 3F4 |

Tous les bus sont unidirectionnels à l'exception des bus données 3D2, 3D4 qui sont bidirectionnels.

Les modules de scrutation comprennent pour chaque conducteur du bus auquel ils sont associés, une mémoire élémentaire. Ces mémoires élémentaires sont agencées de manière à former un registre à décalage dont l'entrée reçoit un signal de substitution 39 par la liaison de test 31 et dont la sortie est reliée à la liaison d'observation 32. Les modules dé scrutation reçoivent de plus un signal de synchronisation 34 également véhiculé par la liaison de test 31.

Les liaisons entre les différents modules de scrutation qui permettent de former le registre à décalage, liaisons de circulation 3AB, 3BC, 3CD, 3DE, 3EF, sont identifiées par trois caractères, le premier étant le chiffre 3, le second étant la lettre de référence du module de scrutation amont, le troisième la lettre de référence du module de scrutation aval.

Ainsi, à chaque impulsion du signal de synchronisation 34, l'ensemble des données stockées dans le registre à décalage progresse d'un bit, un nouveau bit en entrée étant fourni par le signal de substitution tandis que le bit sortant est produit sur la liaison d'observation 32.

Les modules de scrutation dont la structure sera détaillée par la suite seront maintenant décrits en rapport à leurs fonctions.

Le premier module de scrutation 3A permet d'imposer une adresse d'instruction en injectant sur le bus adresse d'instruction 3A2 de la première liaison d'échange L1 les données enregistrées dans ses mémoires élémentaires. Il peut également enregistrer dans ces mêmes mémoires l'adresse d'instruction fournie par la cellule standard 4 sur le bus adresse d'instruction 3A4 correspondant.

Le deuxième module de scrutation 3B permet d'imposer une instruction en injectant sur le bus instruction 3B4 de la deuxième liaison d'échange L2 les données enregistrées dans ses mémoires élémentaires. Il peut également enregistrer dans ses mêmes mémoires l'instruction fournie par la cellule d'application 2 sur le bus instruction 3B2 correspondant.

Le troisième module de scrutation 3C permet d'imposer un signal de contrôle en injectant sur le bus entrées de contrôle 3C4 de la deuxième liaison d'échange L2 les données enregistrées dans ses mémoires élémentaires. Il peut également enregistrer dans ces mêmes mémoires les signaux de contrôle fournis par la cellule d'application 2 sur le bus entrées de contrôle 3C2 correspondant. Les signaux de contrôle peuvent être, par exemple, des interruptions, des indications, des demandes de bus ou de remise à zéro.

Le quatrième module de scrutation 3D qui est associé aux bus données bidirectionnels 3D2, 3D4 permet d'imposer ou d'enregistrer les données sur chacun de ces bus au moyen de ses mémoires élémentaires.

Le cinquième module de scrutation 3E permet d'imposer un signal de contrôle en injectant sur le bus sorties de contrôle 3E2 de la première liaison d'échange L1 les données enregistrées dans ses mémoires élémentaires. Il peut également enregistrer dans ces mêmes mémoires les signaux de contrôle produits par la cellule standard sur le bus sorties de contrôle 3E4 correspondant. Les signaux de contrôle peuvent être, par exemple, des signaux d'écriture, de lecture, d'activation d'autres bus, etc.

Le sixième module de scrutation 3F permet d'imposer une adresse de données en injectant sur le bus adresse de données 3F2 de la première liaison d'échange L1 les informations enregistrées dans ses mémoires élémentaires. Il peut également enregistrer dans ces mêmes mémoires l'adresse de données produite par la cellule standard 4 sur le bus adresse de données 3F4 correspondant.

Ces six modules de scrutation sont prévus pour que le cheminement des informations dans le registre à décalage puisse se faire sans modifier l'un quelconque des signaux présents sur les différents bus, ce qui ressortira plus précisément dans la suite de la description.

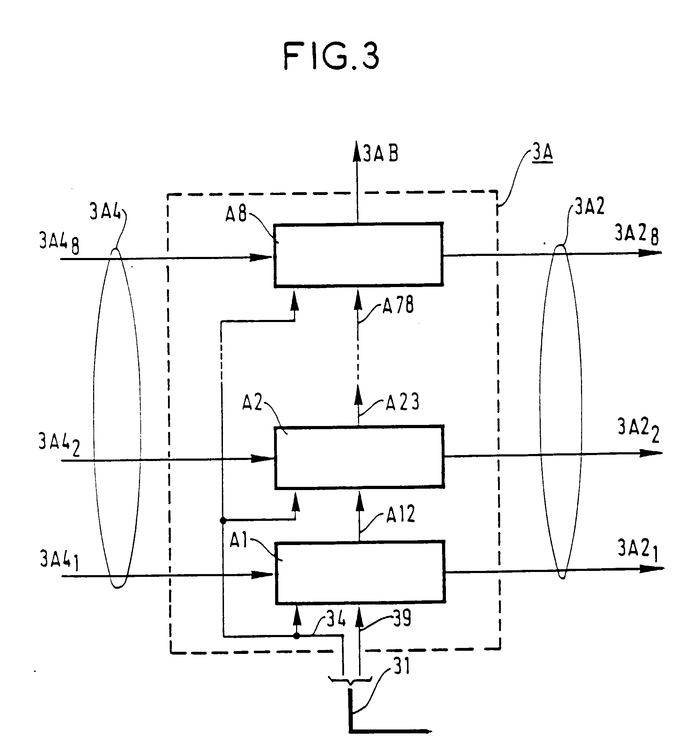

Le premier module de scrutation 3A sera maintenant exposé plus précisément en référence à la figure 3. Les deux bus adresse d'instruction 3A2, 3A4 des première L1 et deuxième L2 liaisons d'échange comprennent chacun huit conducteurs portant comme référence celle du bus auquel ils appartiennent avec un indice qui est un chiffre compris entre 1 et 8 : 3A4₁ à 3A4₈ et 3A2₁ à 3A2₈. Ce module de scrutation 3A comprend pour chaque couple de conducteurs portant le même indice, une unité de scrutation. Les huit unités de scrutation sont identifiées par une référence composée de la lettre A suivie d'un chiffre correspondant à l'indice des conducteurs des bus auxquels elles sont associées. Chaque unité de scrutation reçoit le signal de synchronisation 34. La première A1 reçoit le signal de substitution 39 et produit à destination de la deuxième un premier signal de transfert A12. La deuxième A2 produit à destination de la troisième un deuxième signal de transfert A23 et ainsi de suite jusqu'à la huitième qui reçoit un septième signal de transfert A78 et est reliée au deuxième module de scrutation 3B par la première liaison de circulation 3AB.

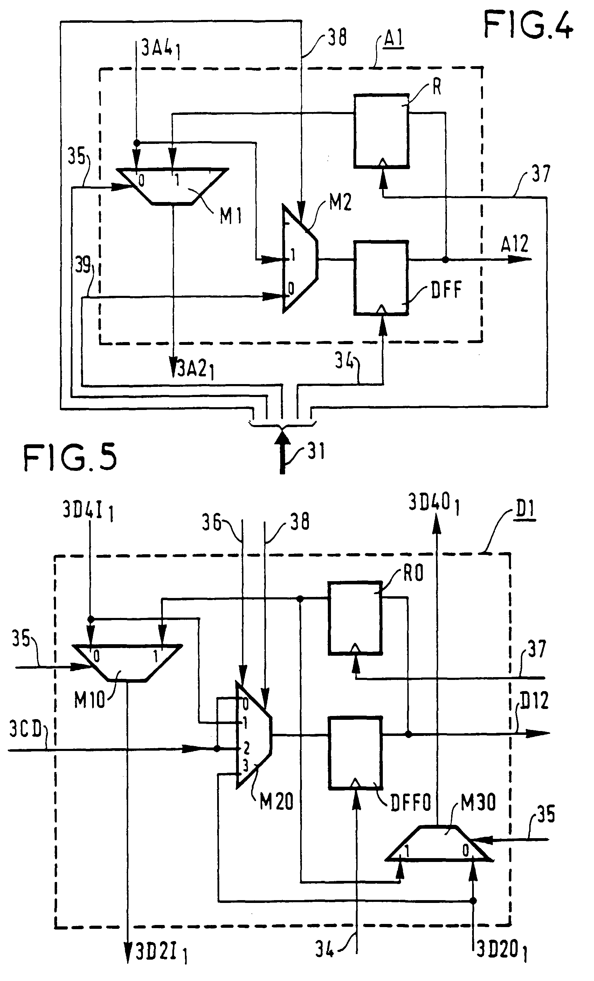

La première unité de scrutation A1 est représentée à la figure 4 dans un mode de réalisation particulier qui ne doit pas être interprété comme une limitation de l'invention. Elle comprend un premier multiplexeur M1 dont l'entrée 0 est reliée à un canal d'entrée de cette unité qui est le premier conducteur 3A4₁ du bus adresse d'instruction 3A4 de la deuxième liaison d'échange L2, dont l'entrée 1 est reliée à la sortie d'un circuit de mémorisation R, dont l'entrée de commande reçoit un premier signal de sélection 35 véhiculé par la liaison de test 31, et dont la sortie est reliée au premier conducteur 3A2₁ du bus adresse d'instruction 3A2 de la première liaison d'échange L1 qui est le canal de sortie de cette unité. Elle comprend un deuxième multiplexeur M2 dont l'entrée 0 reçoit le signal de substitution 39, dont l'entrée 1 est raccordée à l'entrée 0 du premier multiplexeur M1, dont l'entrée de commande reçoit un deuxième signal de sélection 38 et dont la sortie est raccordée à l'entrée d'une mémoire élémentaire DFF. Cette mémoire élémentaire prendra la forme, par exemple, d'une bascule connue sous le nom de bascule D. Elle produit un signal de sortie qui a la valeur qu'avait le signal appliqué sur son entrée de donnée lors du précédent front montant appliqué sur son entrée de synchronisation. Son entrée de synchronisation reçoit le signal de synchronisation 34, tandis que sa sortie produit le premier signal de transfert A12.L'unité de scrutation comprend aussi un circuit de mémorisation R qui sera, par exemple, un élément connu sous le terme anglais de "latch". Il transmet directement son entrée de donnée sur sa sortie pendant l'intervalle de temps où son entrée de synchronisation est à un niveau bas, tandis qu'elle transmet sur sa sortie la valeur qu'avait le signal appliqué sur son entrée de donnée lors du précédent front montant appliqué sur son entrée de synchronisation pendant l'intervalle de temps où cette entrée de synchronisation est à un niveau haut. Il reçoit sur son entrée de donnée le premier signal de transfert A12, sur son entrée de synchronisation un signal de déclenchement 37 véhiculé par la liaison de test 31, et sa sortie est connectée à l'entrée 1 du premier multiplexeur M1, comme cela a déjà été mentionné.

Le signal de déclenchement 37 permet de reproduire la sortie de la mémoire élémentaire DFF sur la sortie du circuit de mémorisation R.

Selon la valeur des deux signaux de sélection 35, 38, les opérations suivantes sont effectuées :
- premier M1 et deuxième M2 multiplexeurs positionnés sur leurs entrées 0, la mémoire élémentaire DFF qui est le premier élément du registre à décalage comme cela apparaîtra par la suite, peut transmettre le signal de substitution 39 sur sa sortie en réponse au signal de synchronisation 34, les premiers conducteurs 3A4₁ et 3A2₁ sont raccordés et sont isolés du reste de l'unité de scrutation, il est ainsi possible de faire progresser le registre à décalage sans modifier le fonctionnement de la cellule standard 4 et de la cellule d'application 2,
- premier M1 et deuxième M2 multiplexeurs respectivement positionnés sur leurs entrées 0 et 1, la mémoire élémentaire DFF peut enregistrer le signal présent sur le premier conducteur 3A4₁ du bus adresse d'instruction 3A4 de la deuxième liaison d'échange L2 en réponse au signal de synchronisation 34, les premiers conducteurs 3A4₁, 3A2₁ étant reliés comme dans le cas précédent, l'enregistrement se produisant donc sans perturbation,
- premier M1 et deuxième M2 multiplexeurs respectivement positionnés sur leurs entrées 1 et 0, le premier conducteur 3A2₁ du bus adresse d'instruction 3A2 de la deuxième liaison d'échange est relié à la sortie du circuit de mémorisation R, la mémoire élémentaire DFF, comme dans le premier cas, peut transmettre le signal de substitution sur sa sortie en réponse au signal de synchronisation 34,
- premier M1 et deuxième M2 multiplexeurs positionnés sur leurs entrées 1, le premier conducteur 3A2₁ du bus adresse d'instruction 3A2 de la première liaison d'échange L1 est relié à la sortie du circuit de mémorisation R, et la mémoire élémentaire DFF peut enregistrer le signal présent sur le premier conducteur 3A4₁ du bus adresse d'instruction 3A4 de la deuxième liaison d'échange L2.

On remarquera que seul le dernier cas justifie la présence du circuit de mémorisation R car il est nécessaire de disposer de deux informations mémorisées. Dans les autres cas, une seule information mémorisée est requise et la mémoire élémentaire est donc suffisante. L'invention s'applique donc également si ce circuit de mémorisation est supprimé, l'entrée 1 du premier multiplexeur M1 étant alors directement raccordée à la sortie de la mémoire élémentaire DFF.

La deuxième unité de scrutation est identique à la première, seuls certains de ces accès diffèrent :
- l'entrée 0 et la sortie de son premier multiplexeur sont reliées respectivement aux deuxièmes conducteurs 3A4₂, 3A2₂ des bus adresse d'instruction 3A4, 3A2 des deuxième L2 et première L1 liaisons d'échange,
- l'entrée 0 de son deuxième multiplexeur reçoit le premier signal de transfert A12,
- sa mémoire élémentaire produit comme signal de sortie le deuxième signal de transfert A23.

L'homme de l'art transposera aisément les modifications précédentes pour définir les accès des unités de scrutation suivantes. Ainsi la nième unité de scrutation diffère de la première uniquement par les points suivants :
- l'entrée 0 et la sortie de son premier multiplexeur sont reliées respectivement aux nièmes conducteurs 3A4ₙ, 3A2ₙ des bus adresse d'instruction 3A4, 3A2,
- l'entrée 0 de son deuxième multiplexeur reçoit le (n - 1)ième signal de transfert A(n - 1)(n),
- sa mémoire élémentaire produit comme signal de sortie le nième signal de transfert A(n)(n + 1) sauf pour la huitième unité de scrutation où ce signal de sortie est injecté sur la première liaison de circulation 3AB.

Le deuxième module de scrutation 3B est identique au premier 3A si ce n'est qu'il faut remplacer les bus adresses d'instruction 3A4, 3A2 des deuxième L2 et première L1 liaisons d'échange respectivement par les bus instructions 3B2, 3B4 des première L1 et deuxième L2 liaisons d'échange, le signal de substitution 39 par le signal présent sur la première liaison de circulation 3AB et cette première liaison de circulation par la deuxième liaison de circulation 3BC.

L'homme du métier transposera facilement ces modifications pour obtenir une définition complète des modules de scrutation suivants si ce n'est que le quatrième 3D est raccordé à des bus bidirectionnels.

Le sixième module de scrutation 3F, d'autre part, présente la particularité d'être raccordé à la liaison d'observation 32 au lieu d'être raccordé à une liaison de circulation.

Il sera admis, dans un premier temps, que les bus de données 3D2, 3D4 sont unidirectionnels, ce qui a pour conséquence de rendre le quatrième module de scrutation 3D identique à tous les autres. Dans ce cas, le registre à décalage est ainsi composé par la mise en série de toutes les mémoires élémentaires de la cellule de test 3 le long d'un chemin de circulation, au moyen des signaux de transfert transitant au sein d'une même unité de scrutation et au moyen de liaisons de circulation pour raccorder ces unités, lorsque le deuxième signal de sélection 38 positionne le deuxième multiplexeur de chaque unité de scrutation sur son entrée 0. Dans ce cas le chemin de circulation est isolé électriquement de chaque conducteur des bus des deux liaisons d'échange L1, L2. Ce registre à décalage est commandé par le signal de synchronisation 34.

Le cas particulier du quatrième module de scrutation 3D sera maintenant examiné. Ce module est raccordé à deux bus données 3D2, 3D4 bidirectionnels des première L1 et deuxième L2 liaisons d'échange qui comprennent chacun 16 conducteurs, huit conducteurs d'entrée portant comme référence celle des bus auquel ils appartiennent suivie d'un I et avec un indice qui est un chiffre compris entre 1 et 8 : 3D2I₁ à 3D2I₈ et 3D4I₁ à 3D4I₈, et huit conducteurs de sortie portant comme référence celle du bus auquel ils appartiennent suivi d'un 0 et avec un indice qui est un chiffre compris entre 1 et 8 : 3D20₁ à 3D20₈ et 3D40₁ à 3D40₈. Le module de scrutation comprend une unité de scrutation pour chaque quadruplet de conducteurs portant le même indice.

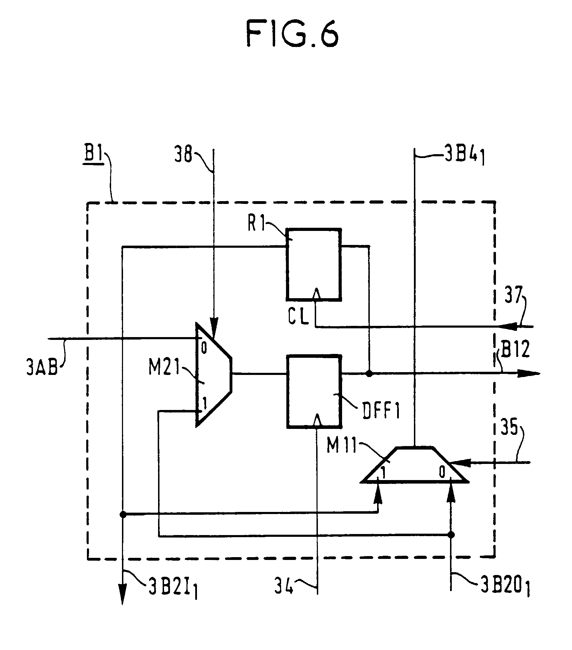

La première unité de scrutation D1 associée aux conducteurs d'indice 1 représentée à la figure 5 comprend un premier multiplexeur M10 dont l'entrée 0 est connectée à un premier canal d'entrée de cette unité qui est le premier conducteur d'entrée 3D4I₁ du bus données 3D4 de la deuxième liaison d'échange L2, dont l'entrée 1 est reliée à la sortie d'un circuit de mémorisation R0 identique à celui décrit précédemment, dont l'entrée de commande reçoit le premier signal de sélection 35 et dont la sortie est raccordée au premier conducteur d'entrée 3D2I₁ du bus données 3D2 de la première liaison d'échange L1 qui est un deuxième canal de sortie de cette unité. Elle comprend un deuxième multiplexeur M20 dont les entrées 0 et 2 sont reliées à la troisième liaison de circulation 3CD, dont l'entrée 1 est connectée à l'entrée 0 du premier multiplexeur M10, dont l'entrée 3 est raccordée à un deuxième canal d'entrée de cette unité qui est le premier conducteur de sortie 3D20₁ du bus données 3D2 de la première liaison d'échange L1, dont les deux entrées de commande reçoivent le deuxième signal de sélection 38 et un troisième signal de sélection 36, et dont la sortie est raccordée à l'entrée d'une mémoire élémentaire DFF0 identique à celle décrite précédemment. Elle comprend également un troisième multiplexeur M30 dont l'entrée 0 est reliée à l'entrée 3 du deuxième multiplexeur M20, dont l'entrée 1 est reliée à la sortie du circuit de mémorisation R0 dont l'entrée de commande reçoit le premier signal de sélection 35 et dont la sortie est reliée au premier conducteur de sortie 3D40₁ du bus données 3D4 de la deuxième liaison d'échange L2 qui est le premier canal de sortie de cette unité.

La mémoire élémentaire DFF0 de cette unité de scrutation D1 dont l'entrée est reliée à la sortie du deuxième multiplexeur M20, reçoit le signal de synchronisation 34 sur son entrée de synchronisation et produit en sortie un premier signal de transfert D12 à destination de la deuxième unité de scrutation D2.

Le circuit de mémorisation R0 de la première unité de scrutation D1 a son entrée de donnée raccordée à la sortie de la mémoire élémentaire DFF0, son entrée de synchronisation reçoit le signal de déclenchement 37 et sa sortie est reliée aux entrées 1 des premier M10 et troisième M30 multiplexeurs.

Le troisième signal de sélection 36 permet d'agir soit sur les conducteurs d'entrée, soit sur les conducteurs de sortie en sélectionnant, soit le groupe d'entrées 0, 1, soit le groupe d'entrées 2, 3 du deuxième multiplexeur M20. Dans le premier cas, le deuxième signal de sélection 38 sélectionne l'entrée 0 ou 1 de la même manière qu'il le fait pour les deuxièmes multiplexeurs des modules de scrutation, et dans le deuxième cas il sélectionne l'entrée 2 ou l'entrée 3 selon qu'il sélectionne respectivement l'entrée 0 ou l'entrée 1 pour les deuxièmes multiplexeurs de ces autres modules.

Le troisième multiplexeur M30 jouant un rôle parfaitement symétrique vis-à-vis du conducteur de sortie à celui que joue le premier multiplexeur M10 vis-à-vis du conducteur d'entrée, son fonctionnement ne sera pas plus détaillé.

Les éléments d'une unité de scrutation du quatrième module de scrutation 3D qui sont ajoutés à une unité de scrutation d'un des autres modules de scrutation étant maintenant décrits, le fonctionnement ne sera pas plus détaillé car il est identique à celui précédemment mentionné.

Par ailleurs, la remarque précédente concernant le circuit de mémorisation R0 s'applique ici aussi. Sans sortir du cadre de l'invention, on peut supprimer ce circuit à condition de raccorder les entrées 1 des premier M10 et troisième M30 multiplexeurs directement à la sortie de la mémoire élémentaire DFF0.

La deuxième unité de scrutation D2 de ce quatrième module de scrutation 3D est identique à la première D1, seuls certains de ces accès diffèrent :
- l'entrée 0 et la sortie de son premier multiplexeur sont reliées respectivement au deuxième conducteur d'entrée 3D4I₂ du bus données 3D4 de la deuxième liaison d'échange L2 et au deuxième conducteur d'entrée 3D2I₂ du bus données 3D2 de la première liaison d'échange L1,
- l'entrée 0 et la sorte de son troisième multiplexeur sont reliées respectivement au deuxième conducteur de sortie 3D20₂ du bus données 3D2 de la première liaison d'échange L1 et au deuxième conducteur de sortie 3D40₂ du bus données 3D4 de la deuxième liaison d'échange L2,
- les entrées 0 et 2 de son deuxième multiplexeurs reçoivent le premier signal de transfert D12,
- sa mémoire élémentaire produit comme signal de sortie un deuxième signal de transfert D23.

L'homme de l'art transposera aisément les modifications précédentes pour définir les accès des unités de scrutation suivantes. Ainsi la nième unité de scrutation diffère de la première sur les points suivants :
- l'entrée 0 et la sortie de son premier multiplexeur sont reliées respectivement au nième conducteur d'entrée 3D4Iₙ du bus données 3D4 de la deuxième liaison d'échange L2 et au nième conducteur d'entrée 3D2Iₙ du bus données 3D2 de la première liaison d'échange L1,
- l'entrée 0 et la sortie de son troisième multiplexeur sont reliées respectivement au nième conducteur de sortie 3D20ₙ du nus données 3D2 de la première liaison d'échange L1 et au nième conducteur de sortie 3D40ₙ du bus données 3D4 de la deuxième liaison d'échange L2,
- les entrées 0 et 2 de son deuxième multiplexeur reçoivent le (n - 1)ième signal de transfert D(n - 1)n,
- sa mémoire élémentaire produit comme signal de sortie le nième signal de transfert D(n)(n + 1) sauf pour la huitième unité de scrutation où ce signal de sortie est injecté sur la quatrième liaison de circulation 3DE.

Il apparaît ainsi que la substitution d'un module de scrutation du type unidirectionnel tel que le premier 3A par un module que l'on peut qualifier de bidirectionnel tel que le quatrième 3D, ne modifie en rien le registre à décalage qui permet d'enregistrer et de modifier les signaux transistant sur les liaisons d'échange L1, L2.

Il peut être intéressant de définir un bus bidirectionnel dans la première liaison d'échange L1 alors que le bus qui lui correspond dans la deuxième liaison d'échange est unidirectionnel. C'est le cas, par exemple, des bus instruction 3B2, 3B4 lorsque la mémoire programme dans laquelle sont enregistrés ces instructions est une mémoire réinscriptible, du type RAM notamment. Il est en effet possible, dans ce cas, de modifier le contenu de cette mémoire au moyen de la cellule de test 3.

Un exemple d'unité de scrutation correspondant à cette application est représenté à la figure 6. On considère qu'il s'agit de la première unité de scrutation B1 du deuxième module de scrutation 3B. Le bus instruction 3B4 de la deuxième liaison d'échange L2 est unidirectionnel et le bus 3B2 de la première liaison d'échange L1 est bidirectionnel. Les notations utilisées précédemment seront reprises ici. Cette unité de scrutation B1 comprend un premier multiplexeur M11 dont l'entrée 0 est raccordée à un canal d'entrée de cette unité qui est le premier conducteur de sortie 3B20₁ du bus instruction 3B2 de la première liaison d'échange, dont l'entrée 1 est raccordée à la sortie d'un circuit de mémorisation R1 identique à ceux précédemment décrits, dont l'entrée de commande reçoit le premier signal de sélection 35 et dont la sortie est reliée au premier conducteur 3B4₁ du bus instruction 3B4 de la deuxième liaison d'échange qui est un canal de sortie de cette unité. Elle comprend un deuxième multiplexeur M21 dont l'entrée 0 est raccordée à la première liaison de circulation 3AB, dont l'entrée 1 est connectée à l'entrée 0 du premier multiplexeur M11, dont l'entrée de commande reçoit le deuxième signal de sélection 38, et dont la sortie est reliée à l'entrée de données d'une mémoire élémentaire DFF1 identique à celles précédemment décrites. Sa mémoire élémentaire DFF1 reçoit sur son entrée de synchronisation le signal de synchronisation 34 et produit en sortie un premier signal de transfert B12. Son circuit de mémorisation R1 reçoit sur son entrée de données, ce premier signal de transfert B12, sur son entrée de synchronisation, le signal de déclenchement 37, et sa sortie est reliée au premier conducteur d'entrée 3B2I₁ du bus instruction 3B2 de la première liaison d'échange L1 qui est un canal auxiliaire de cette unité.

Le fonctionnement de cette unité de scrutation B1 ne sera pas plus détaillé car il se déduit aisément de celui des deux autres unités présenté auparavant.

Par ailleurs, les remarques précédentes concernant le circuit de mémorisation R1 s'appliquent ici aussi. Sans sortir du cadre de l'invention, on peut supprimer ce circuit à condition de raccorder directement l'entrée 1 du premier multiplexeur M11 et le premier conducteur d'entrée 3B2I₁ du bus instruction 3B2 de la première liaison d'échange L1 à la sortie de la mémoire élémentaire DFF1.

Les différents raccordements nécessaires à la réalisation complète de la cellule de test 3 ne seront pas non plus explicités car l'homme de l'art n'aura aucune difficulté à les réaliser conformément aux instructions données plus haut en rapport avec les autres types de module de scrutation.

Ainsi est définie une cellule de test 3 qui permet d'enregistrer et de modifier les différents signaux transitant sur les liaisons d'échange L1, L2 au moyen d'un registre à décalage, la circulation des informations mémorisées dans ce registre pouvant se faire en concomittance avec l'échange de signaux entre la cellule standard 4 et la cellule d'application 2.

On remarquera de plus qu'il est possible de vérifier que les informations fournies par le signal de substitution 39 n'ont pas été altérées par les différents modules de scrutation en les analysant sur la liaison d'observation 32 au fur et à mesure de leur progression dans le registre à décalage.

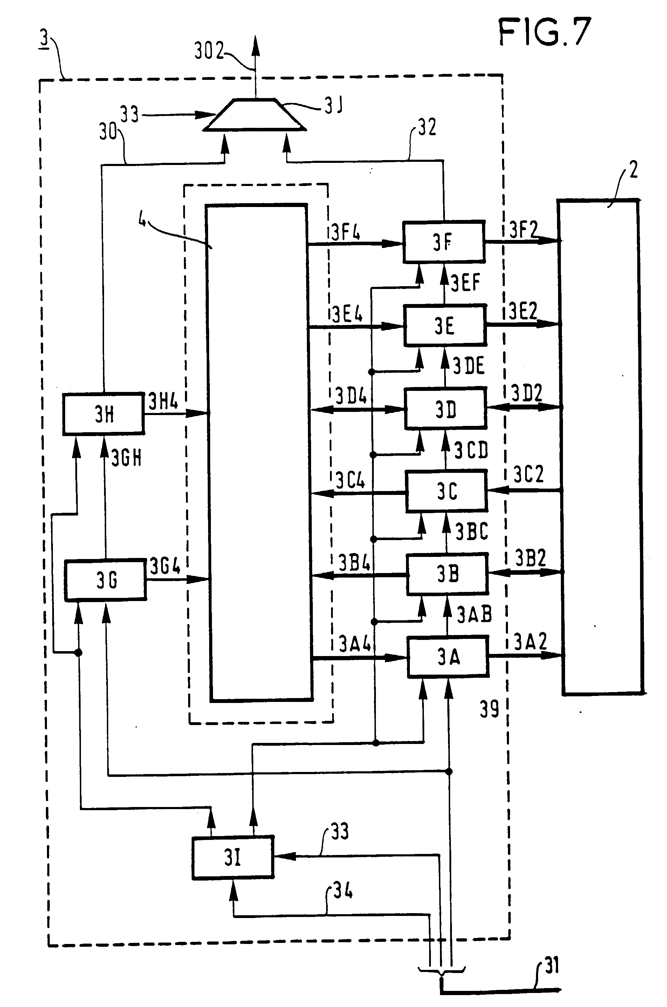

Selon une caractéristique additionnelle, le circuit intégré 1 est également prévu pour modifier le fonctionnement de la cellule standard 4 lorsqu'il s'agit d'un organe programmable tel qu'un microprocesseur. Cette interruption nécessite la fourniture à la cellule standard 4 d'une condition d'arrêt et d'une adresse d'arrêt, ce qui sera explicité par la suite. Les deux informations sont produites par des registres de commande comme cela apparaît à la figure 7.

La cellule de test 3 comprend ici les éléments supplémentaires suivants :
- un registre de condition d'arrêt 3G recevant en entrée le signal de substitution 39 et dont la sortie est raccordée à une liaison de transmission 3GH,
- un registre d'adresse d'arrêt 3H dont l'entrée est raccordée à cette liaison de transmission 3GH et dont la sortie est reliée à une liaison de surveillance 30,
- un commutateur d'horloge 3I qui adresse le signal de synchronisation 34, soit aux différents modules de scrutation 3A à 3F, soit aux deux registres 3G, 3H selon qu'un signal de commutation 33 véhiculé par la liaison de test 31 est respectivement dans un premier ou un second état,
- un multiplexeur 3J de sortie qui produit un signal de certification 302 prenant la valeur de son entrée raccordée à la liaison d'observation 32 ou de celle raccordée à la liaison de surveillance 30 selon que le signal de commutation 33 est respectivement dans son premier ou dans son second état.

Dans ce cas, c'est évidemment le signal de certification 302 qui accède à l'extérieur du circuit intégré 1 à la place de la liaison d'observation 32. Ainsi lorsque le signal de commutation 33 est dans son premier état, la cellule de test se réduit à celle présentée auparavant tandis que lorsqu' il est dans son deuxième état la cellule de test se résume à l'ensemble des deux registres 3G, 3H.

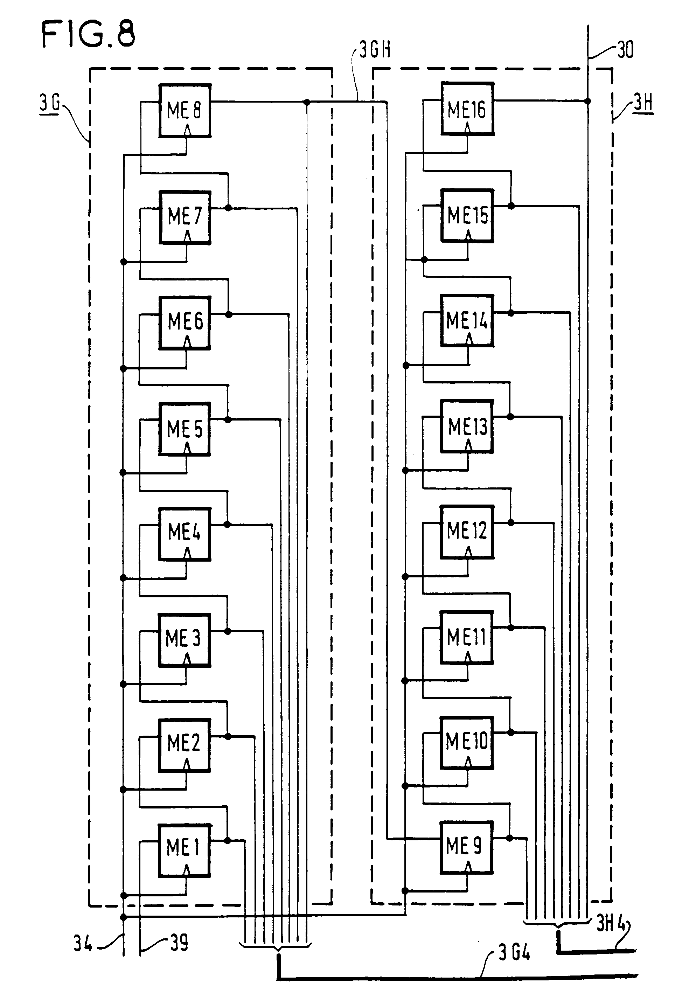

Les deux registres 3G, 3H apparaissent dans un mode de réalisation particulièrement simple à la figure 8. Le registre de condition d'arrêt 3G se présente comme un ensemble de huit mémoires élémentaires ME1 à ME8 du type de celles décrites précédemment. Les sorties de ces mémoires sont reliées chacune à un conducteur d'un bus condition d'arrêt 3G4 qui est raccordé à la cellule standard 4. L'entrée de données de la première mémoire élémentaire ME1 reçoit le signal de substitution 39, tandis que l'entrée de donnée de chacune des autres mémoires élémentaires est reliée à la sortie de la mémoire élémentaire précédente. Les entrées de synchronisation de ces mémoires élémentaires reçoivent toutes le signal de synchronisation 34.

Le registre d'adresse d'arrêt 3H a une structure identique à celle du précédent. Les sorties de ces mémoires élémentaires ME9 à ME16 sont reliées chacune à un conducteur d'un bus adresse d'arrêt 3H4 qui est raccordé à la cellule standard 4. L'entrée de sa première mémoire élémentaire ME9 est reliée à la sortie de la huitième mémoire élémentaire ME8 du registre de condition d'arrêt 3G par la liaison de transmission 3GH. La sortie de sa huitième mémoire élémentaire ME16 est raccordée à la liaison de surveillance 30. Les entrées de synchronisation de chacune de ses mémoires élémentaires reçoivent également le signal de synchronisation 34.

Les bus condition d'arrêt 3G4 et adresse d'arrêt 3H4 sont des bus de commande.

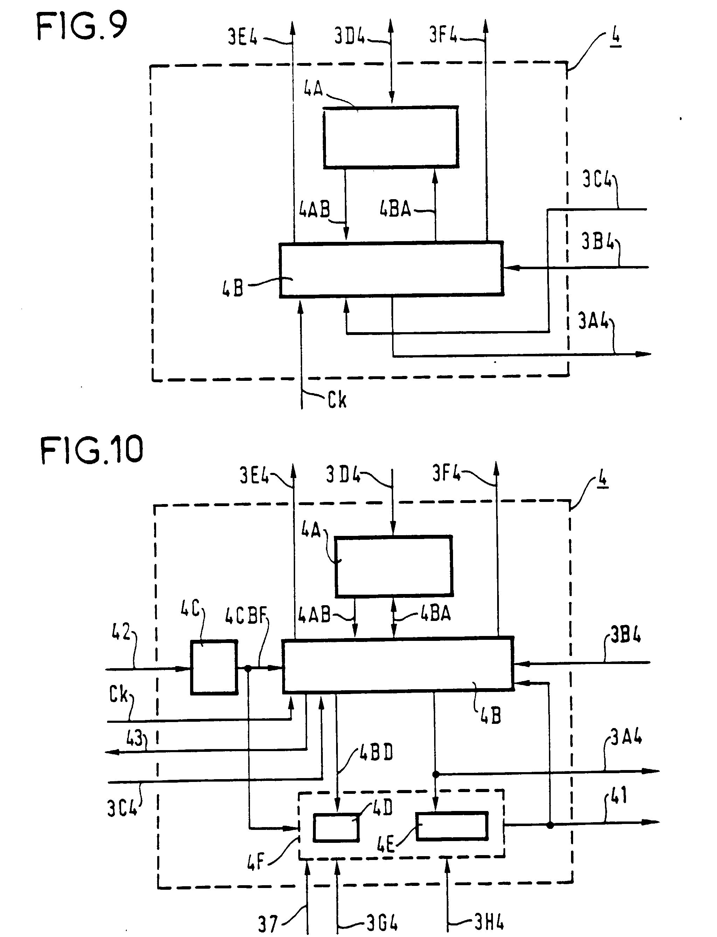

La succession des mémoires élémentaires de ces deux registres définit un deuxième registre à décalage du même type que celui formé par les modules de scrutation. Il fonctionne de la même manière, avec les mêmes commandes, en alternance avec le premier, selon l'état du signal de commutation 33. Il permet de communiquer des informations à la cellule standard 4 qui est représentée dans la figure 9. On remarquera de plus qu'il est possible de vérifier que les informations fournies par le signal de substitution 39 n'ont pas été altérées par ces registres en les analysant sur la liaison de surveillance 30 au fur et à mesure de leur progression dans ce deuxième registre à décalage.

Cette cellule standard 4 est composée d'un module d'opération 4A et d'un module d'instruction 48 pourvu d'un séquenceur et d'un décodeur d'instruction, cette structure étant connue sous le nom de structure de type "Harvard".

Le module d'instruction 40 reçoit par le bus instruction 3B4 une instruction de la mémoire de programme enregistrée à l'adresse qu'il produit sur le bus adresse d'instruction 3A4. Il est de plus relié au bus entrées de contrôle 3C4. Le séquenceur fonctionne en synchronisme avec le signal d'horloge Ck. A l'aide des bus adresse de données 3F4 et contrôle de données 3E4 ce séquenceur permet l'échange des données entre une mémoire de données figurant dans la cellule d'application 2 et le module d'opération 4A par le bus données 3D4. Le décodeur d'instruction élabore à chaque cycle un signal de commande 4BA du module d'opération qui produit en retour un signal de situation 4AB à destination du séquenceur.

Les modifications apportées à la cellule standard 4 seront maintenant exposées en référence à la figure 10. Le module d'opération 4A de cette cellule est identique à ceux connus dans ce type de dispositif, ce qui est un avantage de l'invention.

Le module d'instruction 4B, de manière connue également, accède aux bus adresse d'instruction 3A4, instruction 3B4, entrées de contrôle 3C4, sorties de contrôle 3E4, adresse de données 3F4 et est pourvu d'un accès d'interruption permettant d'arrêter son fonctionnement. Dans le cadre de l'invention, ce module est de plus prévu pour délivrer un signal d'état 4BD renseignant sur l'état du séquenceur, et un signal d'état d'avancement 43 signifiant l'état d'avancement de l'instruction en cours d'exécution. Cette information est particulièrement utile lorsque l'instruction se déroule sur plusieurs cycles du séquenceur, ce qui est le cas par exemple de transferts de données lorsque ces données sont acheminées en plusieurs étapes sur le bus données. Il est également prévu pour recevoir un signal de mode de fonctionnement 4CBF déterminant son fonctionnement. Cette opération se réalise aisément lors de la spécification du séquenceur et ne posera donc pas de difficultés particulières à l'homme de l'art. En conséquence, le fonctionnement de ce module sera analysé en référence à ce signal de mode de fonctionnement 4CBF dès que les autres éléments incorporés à la cellule standard 4 auront été exposés.

Cette cellule standard 4 comprend un module de décodage 4C qui reçoit un signal de type de fonctionnement 42 produit à l'extérieur du circuit intégré 1 sur quatre fils par exemple et le transforme pour générer le signal de mode de fonctionnement 4CBF afin que celui-ci soit dans un format convenant au module d'instruction 4B. Ce module de décodage est une simple interface.

La cellule standard 4 comprend également un module de comparaison 4F qui effectue la comparaison entre des signaux issus du module d'instruction 4B et les signaux provenant des registres de condition d'arrêt 3G et d'adresse d'arrêt 3H pour produire un signal de coïncidence 41 en cas d'égalité, pour certains des états du signal de mode de fonctionnement 4CBF. Ce signal de coïncidence 41 est injecté sur l'accès d'interruption du module d'instruction 48. Dans l'exemple présenté donné à titre purement indicatif, ce module de comparaison comprend un premier comparateur 4D qui reçoit le signal d'état 4BD et le compare à l'état du bus condition d'arrêt 3G4 et un deuxième comparateur 4E effectuant la comparaison des signaux présents sur le bus adresse d'instruction 3A4 et sur le bus adresse d'arrêt 3H4.

Le signal de mode de fonctionnement 4CBF peut prendre différents états parmi lesquels, ceux qui suivent produisent un fonctionnement particulier de la cellule standard 4 :
- premier état :
   fonctionnement normal. la cellule standard se réduit à une cellule de type connu et son fonctionnement n'est pas modifié,
- deuxième état :
   transfert des données présentes sur les bus de condition d'arrêt 3G4 et d'adresse d'arrêt 3H4 au module de comparaison 4F,
- troisième état :
   production du signal de coïncidence 41 lorsque les deux comparateurs 4D, 4E ont détecté une identité,
- quatrième état :
   production du signal de coïncidence 41 dans les mêmes conditions et interruption du fonctionnement du module d'instruction 4B,
- cinquième état :
   interruption du fonctionnement module d'instruction 4B dès l'instruction suivant l'apparition de cet état,
- sixième état :
   fonctionnement pas à pas, interruption du fonctionnement du module d'instruction 4B après l'exécution de chaque instruction,
- septième état :
   exécution de l'instruction présente sur le bus instruction 3B4 et interruption du fonctionnement du module d'instruction 4B,
- huitième état :
   retour au fonctionnement du module d'instruction 4B suite à une interruption produite par un autre état.

Selon une caractéristique optionnelle, le module de comparaison 4F ne produit pas le signal de coïncidence 41 si le signal de déclenchement 37 est présent lorsque le signal de mode de fonctionnement est dans l'un de ses quatrième à septième état, ce qui a pour effet d'empêcher une interruption du module d'instruction 4B.

Les modifications de la cellule standard présentées ci-dessus permettent, grâce au signal d'état d'avancement 43 et au signal de coïncidence 41, à l'équipement de test et d'émulation d'agir sur la cellule de test 3 en fonction de l'état des signaux auxquels accède le module d'instruction 4B. Cet équipement peut notamment produire les différents signaux véhiculés par la liaison de test 31 tels que les trois signaux de sélection 35, 36, 38 et le signal de déclenchement 37 en réponse au signal de coïncidence 41. Le signal de coïncidence étant produit au début de l'exécution d'une instruction, l'équipement de test et d'émulation peut déclencher l'enregistrement des signaux présents sur les différents bus reliant la cellule standard 4 à la cellule d'application 2 au cours ou à la fin de cette instruction et provoquer l'interruption du fonctionnement de la cellule standard à la fin de cette instruction.

Il est ainsi possible, lorsque le programme enregistré dans la mémoire programme présente un fonctionnement anormal et n'atteint pas un point d'arrêt prévu, d'interrompre l'exécution de ce programme par la production du signal de mode de fonctionnement 4CBF, dans son cinquième état. L'état des différents bus et notamment celui du bus adresse d'instruction 3A4 est alors accessible, ce qui n'est pas le cas lorsque l'on procède, de manière connue, à une remise à zéro du composant.

Il est également possible d'enregistrer dans la cellule de test 3, l'état de tous les bus de liaison entre la cellule standard 4 et la cellule d'application 2 sans modifier le fonctionnement du module d'instruction 4B, ceci en réponse au signal de coïncidence 41.

L'invention s'applique naturellement quel que soit le nombre de registres de commande et de bus de commandes, le module de comparaison 4F étant agencé en conséquence.

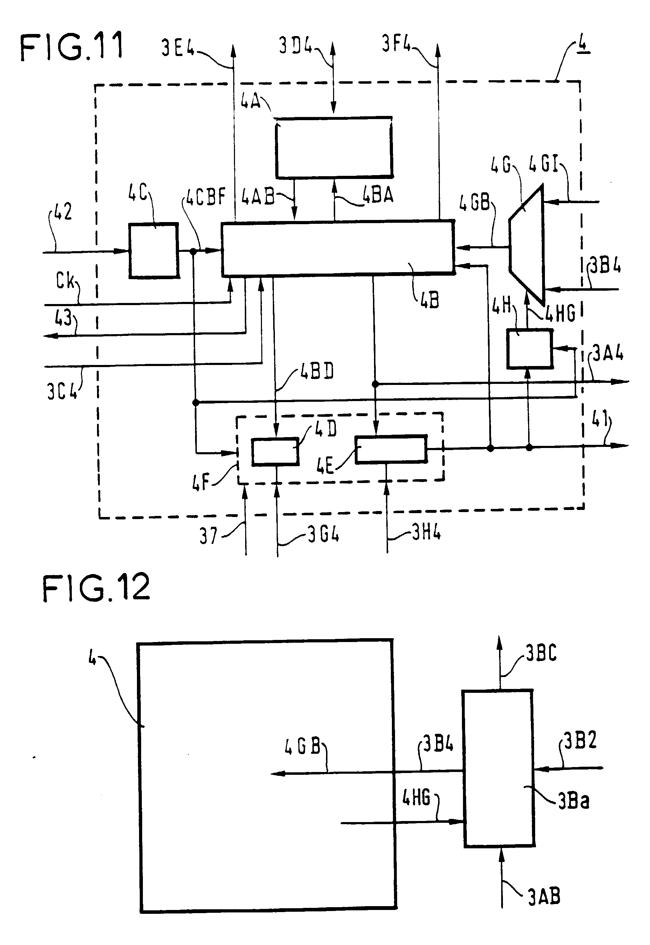

La mémoire de programme de la cellule standard 4 est couramment une mémoire non réinscriptible, du type ROM par exemple. Dans ce cas il n'est donc pas possible de corriger une erreur du programme. Dans une variante de réalisation du circuit intégré, il est prévu d'adjoindre à cette mémoire, une mémoire de substitution réinscriptible de type RAM par exemple pour corriger une erreur éventuelle. Les moyens de substitution qui permettent de remplacer une série d'instruction de la mémoire programme par une série d'instruction de la mémoire de substitution apparaissent à la figure 11.

Ils comprennent un circuit de déroutement 4H qui produit un signal de déroutement 4HG pour un neuvième état du signal de mode de fonctionnement 4CBF lorsque le signal de coïncidence 41 est présent. Ils comprennent également un multiplexeur de déroutement 4G qui produit sur un bus complémentaire d'instruction 4GB raccordé à la place du bus d'instruction 3B4 au module d'instruction 4B, une instruction du branchement 4GI si le signal de déroutement 4HG est présent et qui raccorde directement le bus d'instruction 3B4 au bus d'instruction complémentaire 4GB dans le cas contraire. Dans l'exemple de réalisation présenté qui ne doit pas être considéré comme une limitation de l'invention, l'instruction de branchement 4GI est une instruction de branchement absolu qui provient d'un circuit câblé.

La mémoire de substitution qui n'est pas représentée dans la figure peut, dans une première configuration, être accédée par le bus adresse d'instruction 3A4 moyennant un circuit de décodage aiguillant l'adresse d'instruction soit vers la mémoire de programme, soit vers cette mémoire de substitution selon le format de l'adresse. Ces moyens techniques étant à la portée de l'homme de l'art ne seront pas plus détaillés ici. L'écriture et la lecture peuvent alors se faire au moyen du deuxième module de scrutation 3B de la cellule de test 3. Dans une deuxième configuration, cette mémoire de substitution peut être accédée directement par le module d'instruction 4B en écriture et en lecture respectivement pour un dixième et un onzième état du signal de mode de fonctionnement 4B. Dans tous les cas, la dernière instruction exécutable de cette mémoire est un retour à la mémoire de programme.

Il est clair qu'en utilisant des moyens similaires à ceux présentés ci-dessus et les connaissances de l'homme du métier, on peut réaliser un dispositif de déroutement capable de pallier plusieurs erreurs dans la mémoire programme sans sortir du cadre de l'invention.

Lorsque l'erreur présente dans la mémoire programme se limite à une seule instruction, il est possible de corriger cette erreur d'une manière plus simple, tel que cela apparaît dans la figure 12.

Dans ce cas le deuxième module de scrutation 3B est modifié en un module auxiliaire 3Ba de la manière suivante. Le premier multiplexeur de chaque unité de scrutation B1 à B8 de ce module est commandé non pas par le premier signal de sélection 35, mais par un signal qui est la somme logique de ce premier signal de sélection et du signal de déroutement 4HG réalisée, par exemple, au moyen d'un opérateur logique OU.

Par ailleurs, le multiplexeur de déroutement 4G est supprimé, le bus instruction 3B4 et le bus complémentaire d'instruction 4GB étant reliés directement.

Il est ainsi possible de remplacer une instruction erronée par l'information présente en sortie des mémoires élémentaires de ce module de scrutation auxiliaire 3Ba.

L'invention a été présentée en relation avec un circuit intégré comprenant cinq bus unidirectionnels de huit conducteurs et un bus bidirectionnel de seize conducteurs qui relient la cellule standard 4 et la cellule d'application 2. Elle ne se limite pas à ce cas particulier et si l'on définit une liaison élémentaire entre ces deux cellules comme liaison de communication, c'est-à-dire un conducteur d'un bus unidirectionnel ou une paire de conducteurs d'un bus bidirectionnel, elle s'applique quel que soit le nombre de ces liaisons de communication et quelle que soit la manière dont elles sont agencées.

Il va sans dire que l'invention concerne également le cas des circuits intégrés comprenant plusieurs cellules standard et/ou plusieurs cellules d'application, ce dernier terme devant s'entendre de manière très générale.

## Revendications

1. Circuit intégré (1) comprenant une cellule standard (4), une cellule d'application (2) et une cellule de test (3) prévue notamment pour enregistrer ou pour modifier de l'extérieur du circuit intégré la valeur de signaux de communication transitant entre ladite cellule standard et ladite cellule d'application, ladite cellule standard exécutant des instructions fournies sur un bus instruction (3B4) par une mémoire de programme localisée dans ladite cellule d'application en réponse à une adresse d'instruction véhiculée par un bus adresse d'instruction (3A4), les conducteurs de ces bus constituant des liaisons de communication, caractérisé en ce que ladite cellule de test comprend des moyens de dérivation pour remplacer une instruction erronée au moins de ladite mémoire de programme par une instruction de remplacement préalablement enregistrée dans ledit circuit intégré en réponse à un état déterminé de certaines au moins desdites liaisons de communication.

2. Circuit intégré comprenant une cellule standard, une cellule d'application et une cellule de test selon la revendication 1, caractérisé en ce que ladite cellule de test (3) comprenant pour chacune desdites liaisons de communication une unité de scrutation pourvue d'une mémoire élémentaire (DFF) connectée à certains moments au moins sur ces liaisons, lesdites mémoires élémentaires étant reliées entre elles pour former un premier registre à décalage, cette cellule de test (3) comprenant aussi un deuxième registre à décalage pourvu d'au moins un premier registre de commande (3H) dont les sorties sont reliées chacune à un conducteur d'un premier bus de commande (3H 4), ledit circuit intégré comprend un module de comparaison (4F) auquel sont respectivement connectés, d'une part ledit bus de commande et d'autre part certaines au moins desdites liaisons de comunication pour produire un signal de coïncidence (41) en cas d'identité des signaux qui lui sont respectivement fournis.

3. Circuit intégré comprenant une cellule standard, une cellule d'application et une cellule de test selon la revendication 2, caractérisé en ce que ladite cellule standard (4) fonctionnant en réponse à un signal de mode de fonctionnement (4CBF), elle comprend un circuit de déroutement (4H) produisant un signal de déroutement (4HG) pour un état déterminé dudit signal de mode de fonctionnement si ledit signal de coïncidence (41) est présent.

4. Circuit intégré comprenant une cellule standard, une cellule d'application et une cellule de test selon la revendication 3, caractérisé en ce que lesdits moyens de dérivation comprennent une mémoire de substitution dont la dernière instruction exécutable est un retour à ladite mémoire de programme, un multiplexeur de déroutement (4G) dont la sortie est raccordée à la place dudit bus d'instruction (3 B 4) dans ladite cellule standard (4), dont une première entrée sélectionnée par ledit signal de déroutement (4 H G) reçoit une instruction de branchement (4 G I) à ladite mémoire de substitution et dont la deuxième entrée sélectionnée en l'absence dudit signal de déroutement (4 H G) est raccordée audit bus d'instruction (3 B 4).

5. Circuit intégré comprenant une cellule standard, une cellule d'application et une cellule de test selon la revendication 4, caractérisé en ce que ladite mémoire de substitution est accédée par ledit bus adresse d'instruction (3 A 4) moyennant un circuit de décodage, l'écriture et la lecture se faisant par l'intermédiaire desdites unités de scrutation (B 1) dudit premier registre à décalage associées audit bus instruction (3 B 2, 3 B 4).

6. Circuit intégré comprenant une cellule standard, une cellule d'application et une cellule de test selon la revendication 4, caractérisé en ce que ladite mémoire de substitution est accédée directement par ladite cellule standard (4), l'écriture et la lecture étant commandées par deux nouveaux états dudit signal de mode de fonctionnement (4 C B F).

7. Circuit intégré comprenant une cellule standard, une cellule d'application et une cellule de test selon la revendication 3, caractérisé en ce que lesdites unités de scrutation associées audit bus d'instruction (3 B 4) dont les liaisons de communication sont composées chacune d'un canal d'entrée (3 B 2 0₁) et d'un canal de sortie (3 B 4₁) comprennent chacune (B1) un premier multiplexeur (M11) dont la première entrée est reliée audit canal d'entrée (3 B 20₁) dont la sortie est reliée audit canal de sortie (3 B 4) et dont l'entrée de commande reçoit ledit signal de déroutement (4 H G), un deuxième multiplexeur (M21) dont la deuxième entrée est reliée audit canal d'entrée (3 B 2 0₁) et dont la sortie est reliée à l'entrée d'une mémoire élémentaire (DFF1), cette mémoire élémentaire ayant sa sortie reliée à la deuxième entrée dudit premier multiplexeur (M11), ledit premier registre à décalage comprenant la succession desdites mémoires élémentaires raccordées chacune à la première entrée du deuxième multiplexeur de l'unité de scrutation suivante, les signaux de sorties desdites mémoires élémentaires, préalablement chargées au moyen dudit premier registre à décalage formant ladite instruction de remplacement et remplaçant alors ladite instruction erronée suite à l'apparition dudit signal de déroutement.

8. Circuit intégré comprenant une cellule standard, une cellule d'application et une cellule de test selon la revendication 7, caractérisé en ce que ladite unité de scrutation (B1) comprend de plus un circuit de mémorisation (R1) dont l'entrée de donnée est reliée à la sortie de ladite mémoire élémentaire (DFF1) et dont l'entrée de synchronisation reçoit un signal de déclenchement (37), la deuxième entrée dudit premier multiplexeur (M11) étant reliée non plus à la sortie de ladite mémoire élémentaire (DFF1) mais à la sortie dudit circuit de mémorisation (R1).

## Patentansprüche

1. Integrierte Schaltung (1) mit einer Standardzelle (4), einer Anwendungszelle (2) und einer Testzelle (3), insbesondere um den Wert von Nachrichtensignalen, die zwischen der Standardzelle und der Anwendungszelle übertragen werden, zu registrieren oder von außerhalb der integrierten Schaltung zu verändern, wobei die Standardzelle Befehle ausführt, die auf einem Befehlsbus (3B4) von einem in der Anwendungszelle liegenden Programmspeicher aufgrund einer Befehlsadresse geliefert werden, die über einen Befehlsadressenbus (3A4) übermittelt wird, wobei die Leiter dieser Busleitungen die Nachrichtenverbindungen bilden, dadurch gekennzeichnet, daß die Testzelle Ableitungsmittel aufweist, um mindestens einen fehlerhaften Befehl im Programmspeicher durch einen Ersatzbefehl zu ersetzen, der vorher in der integrierten Schaltung aufgrund eines bestimmten Zustands zumindest einiger der Nachrichtenverbindungen gespeichert wurde.

2. Integrierte Schaltung mit einer Standardzelle, einer Anwendungszelle und einer Testzelle nach Anspruch 1, dadurch gekennzeichnet, daß die Testzelle (3) für jede der Nachrichtenverbindungen eine Abfrageeinheit mit einem Elementarspeicher (DFF) enthält, die zumindest in gewissen Augenblicken an diese Verbindungen angeschlossen ist, daß die Elementarspeicher miteinander verbunden ein Schieberegister bilden, daß die Testzelle (3) weiter ein zweites Schieberegister mit mindestens einem ersten Steuerregister (3H) aufweist, dessen Ausgänge je an einen Leiter einer ersten Steuerbusleitung (3H4) angeschlossen sind, und daß die integrierte Schaltung einen Vergleichsmodul (4F) aufweist, an den einerseits der Steuerbus und andererseits zumindest einige der Nachrichtenverbindungen angeschlossen sind, um ein Koinzidenzsignal (41) im Fall der Identität der dem Modul gelieferten Signale zu erzeugen.

3. Integrierte Schaltung mit einer Standardzelle, einer Anwendungszelle und einer Testzelle nach Anspruch 2, dadurch gekennzeichnet, daß die Standardzelle (4) von einem Betriebsmodussignal (4CBF) gesteuert wird und eine Umleitungsschaltung (4H) enthält, die ein Umleitungssignal (4HG) für einen bestimmten Zustand des Betriebsmodussignals erzeugt, wenn das Koinzidenzsignal (41) vorliegt.

4. Integrierte Schaltung mit einer Standardzelle, einer Anwendungszelle und einer Testzelle nach Anspruch 3, dadurch gekennzeichnet, daß die Ableitungsmittel einen Ersatzspeicher, dessen letzter ausführbarer Befehl eine Rückkehr zum Programmspeicher ist, und einen Umleitungsmultiplexer (4G) enthält, dessen Ausgang anstelle der Befehlsbusleitung (3B4) in der Standardzelle (4) angeschlossen ist, dessen erster Eingang, der vom Umleitungssignal (4HG) ausgewählt wird, einen Abzweigungsbefehl (4GI) in Richtung zum Ersatzspeicher empfängt und dessen zweiter Eingang, der bei Abwesenheit des Umleitungssignals (4HG) ausgewählt wird, mit dem Befehlsbus (3B4) verbunden ist.

5. Integrierte Schaltung mit einer Standardzelle, einer Anwendungszelle und einer Testzelle nach Anspruch 4, dadurch gekennzeichnet, daß der Befehlsadressenbus (3A4) über eine Dekodierschaltung Zugang zum Ersatzspeicher hat, wobei das Lesen und das Schreiben über die dem Befehlsbus (3B2, 3B4) zugeordneten Abfrageeinheiten (B1) des ersten Schieberegisters erfolgen.

6. Integrierte Schaltung mit einer Standardzelle, einer Anwendungszelle und einer Testzelle nach Anspruch 4, dadurch gekennzeichnet, daß die Standardzelle (4) unmittelbar zum Ersatzspeicher Zugang hat, wobei das Lesen und das Schreiben durch zwei neue Zustände des Betriebsmodussignals (4CBF) gesteuert werden.

7. Integrierte Schaltung mit einer Standardzelle, einer Anwendungszelle und einer Testzelle nach Anspruch 3, dadurch gekennzeichnet, daß die Abfrageeinheiten (B1), die dem Befehlsbus (3B4) zugeordnet sind, dessen Nachrichtenverbindungen je aus einem Eingangskanal (3B20₁) und einem Ausgangskanal (3B4₁) bestehen, je einen ersten Multiplexer (M11), dessen erster Eingang an den Eingangskanal (3B20₁), dessen Ausgang an den Ausgangskanal (3B4) angeschlossen ist und dessen Steuereingang das Umleitungssignal (4HG) empfängt, und einen zweiten Multiplexer (M21) enthalten, dessen zweiter Eingang an den Eingangskanal (3B20₁) und dessen Ausgang an den Eingang eines Elementarspeichers (DFF1) angeschlossen ist, wobei dieser Elementarspeicher mit seinem Ausgang an den zweiten Eingang des ersten Multiplexers (M11) angeschlossen ist und das erste Schieberegister die Folge der je an den ersten Eingang des zweiten Multiplexers der nächstfolgenden Abfrageeinheit angeschlossenen Elementarspeicher enthält, wobei die Ausgangssignale der Elementarspeicher, die vorher mit Hilfe des ersten Schieberegisters geladen wurden, den Ersatzbefehl bilden und den fehlerhaften Befehl ersetzen, wenn das Umleitungssignal auftritt.

8. Integrierte Schaltung mit einer Standardzelle, einer Anwendungszelle und einer Testzelle nach Anspruch 7, dadurch gekennzeichnet, daß die Abfrageeinheit (B1) außerdem eine Speicherschaltung (R1) enthält, deren Dateneingang an den Ausgang des Elementarspeichers (DFF1) angeschlossen ist und deren Synchronisationseingang ein Auslösesignal (37) empfängt, während der zweite Eingang des ersten Multiplexers (M11) nicht mehr an den Ausgang des Elementarspeichers (DFF1), sondern an den Ausgang der Speicherschaltung (R1) angeschlossen ist.

## Claims

1. Integrated circuit (1) comprising a standard cell (4), an application cell (2) and a test cell (3) designed in particular to store or to modify from outside the integrated circuit the value of communication signals passing between said standard cell and said application cell, said standard cell executing instructions provided on an instruction bus (3B4) by a program memory located in said application cell in response to an instruction address carried by an instruction address bus (3A4), the conductors of said buses constituting communication links, characterised in that said test cell comprises branching means for replacing at least one erroneous instruction from said program memory with a replacement instruction previously stored in said integrated circuit in response to a particular state of some at least of said communication links.

2. Integrated circuit comprising a standard cell, an application cell and a test cell according to claim 1 characterised in that said test cell (3) comprises for each of said communication links a scanning unit provided with a unit memory (DFF) connected at some times at least to said links, said unit memories are interconnected to form a first shift register, said test cell (3) comprises also a second shift register provided with at least a first control register (3H) the outputs of which are each connected to a conductor of a first control bus (3H4), said integrated circuit comprises a comparator module (4F) to which are respectively connected said control bus and some at least of said communication links to produce a coincidence signal (41) if the signals respectively supplied to it are identical.

3. Integrated circuit comprising a standard cell, an application cell and a test cell according to claim 2 characterised in that said standard cell (4) operates in response to an operating mode signal (4CBF), it comprises a trap circuit (4H) producing a trap signal (4HG) for a particular state of said operating mode signal if said coincidence signal (41) is present.

4. Integrated circuit comprising a standard cell, an application cell and a test cell according to claim 3 characterised in that said branching means comprise a substitution memory the last instruction that can be executed in which is an instruction to return to said program memory, a trap multiplexer (4G) the output of which is connected in place of said instruction bus (3B4) in said standard cell (4), a first input of which selected by said trap signal (4HG) receives an instruction (4GI) to branch to said substitution memory and the second input of which selected in the absence of said trap signal (4HG) is connected to said instruction bus (3B4).

5. Integrated circuit comprising a standard cell, an application cell and a test cell according to claim 4 characterised in that said substitution memory is accessed by said instruction address bus (3A4) by means of a decoder circuit and writing and reading are effected by means of said scanning units (B1) of said first shift register associated with said instruction bus (3B2, 3B4).

6. Integrated circuit comprising a standard cell, an application cell and a test cell according to claim 4 characterised in that said substitution memory is accessed directly by said standard cell (4) and writing and reading are commanded by two new states of said operating mode signal (4CBF).

7. Integrated circuit comprising a standard cell, an application cell and a test cell according to claim 3 characterised in that said scanning units associated with said instruction bus (3B4) whose communication links each comprise an input channel (3B20₁) and an output channel (3B4₁) each comprise (B1) a first multiplexer (M11) the first input of which is connected to said input channel (3B20₁), the output of which is connected to said output channel (3B4) and the control input of which receives said trap signal (4HG), a second multiplexer (M21) the second input of which is connected to said input channel (3820₁) and the output of which is connected to the input of a unit memory (DFF1) having its output connected to the second input of said first multiplexer (M11), said first shift register comprising the succession of said unit memories each connected to the first input of the second multiplexer of the next scanning unit, the output signals of said unit memories previously loaded by means of said first shift register forming said replacement instruction and then replacing said erroneous instruction following the appearance of said trap signal.

8. Integrated circuit comprising a standard cell, an application cell and a test cell according to claim 7 characterised in that said scanning unit (B1) further comprises a memory circuit (R1) whose data input is connected to the output of said unit memory (DFF1) and whose synchronisation input receives a trigger signal (37) and the second input of said first multiplexer (M11) is connected not to the output of said unit memory (DFF1) but instead to the output of said memory circuit (R1).
